# EUROPEAN PATENT APPLICATION

(11) **EP 4 411 018 A1**
(43) Date of publication of application: **07.08.2024**
(21) Application number: 24154978.1
(22) Date of filing: 31.01.2024
(51) Int. Cl.: C23C 14/04, H10K 71/16, C23C 14/12, C23C 14/24

(54) **MASK, MASK ASSEMBLY INCLUDING THE SAME, DISPLAY PANEL MANUFACTURING APPARATUS INCLUDING THE SAME, AND METHOD OF MANUFACTURING DISPLAY PANEL USING THE SAME**

(30) Priority: 03.02.2023 KR 20230015171
(71) Applicant: Samsung Display Co., Ltd., Yongin-si, Gyeonggi-do 17113 (KR)
(72) Inventor: KIM, Sang Hoon, 17113 Giheung-gu, Yongin-si, Gyeonggi-do (KR); LEE, Seung Jin, 17113 Giheung-gu, Yongin-si, Gyeonggi-do (KR); KANG, Yeon Ju, 17113 Giheung-gu, Yongin-si, Gyeonggi-do (KR); LEE, Sang Shin, 17113 Giheung-gu, Yongin-si (KR)
(74) Representative: Dr. Weitzel & Partner

(57) **Abstract**

A mask including a sensor area including at least one half-etched area, a first deposition area disposed external to the sensor area, and a second deposition area disposed in the sensor area. The mask, a mask assembly including the mask, a display panel manufacturing apparatus including the mask assembly, and a method of manufacturing a display panel using the display panel manufacturing apparatus in accordance with embodiments of the disclosure may improve deposition quality.

## Description

### BACKGROUND

### 1. Technical Field

Various embodiments of the disclosure relate to a mask, a mask assembly including the mask, a display panel manufacturing apparatus including the mask assembly, and a method of manufacturing a display panel using the display panel manufacturing apparatus.

### 2. Description of the Related Art

With the development of information technology, the importance of a display device, which may be a connection medium between a user and information, has been emphasized. Owing to the importance of display devices, the use of various kinds of display devices, such as a liquid crystal display device and an organic light emitting display device, has increased.

For example, a display panel provided to form the organic light emitting display device may include a light emitting element. The light emitting element may include an emission layer including organic material.

As a method for forming the emission layer on the display panel, a deposition process in which deposition material passes through a mask (e.g., a fine metal mask (FMM)) may be used. The mask, which may be used during the deposition process, may be extremely thin, so that the mask may be stretched by applying tensile force to the mask, and the deposition material may pass through the stretched mask. As such, in an operation of stretching the mask, if different tensile force may be partially applied to the mask, wrinkles may occur in the mask, thus resulting in deterioration in deposition quality. A method to overcome the foregoing problem has been needed.

### SUMMARY

The invention is defined by the independent claims. Various embodiments of the disclosure may be directed to a mask capable of improving deposition quality, a mask assembly including the mask, a display panel manufacturing apparatus including the mask assembly, and a method of manufacturing a display panel using the display panel manufacturing apparatus.

An embodiment of the disclosure provides a mask including a sensor area including at least one half-etched area, a first deposition area disposed external to the sensor area, and a second deposition area disposed in the sensor area.

Each of the first and the second deposition areas may include an opening. Each opening of the first and the second deposition areas may include a first etched area formed by etching the mask in a direction from a first surface of the mask toward a second surface of the mask, and a second etched area formed by etching the mask in a direction from the second surface of the mask toward the first surface of the mask.

The half-etched area may include the second etched area.

The depth of the second etched area may be equal to or greater than half of the thickness of the mask.

The sensor area may have a shape selected from a circular ring-type and a pill-like ring-type.

An embodiment of the disclosure provides a mask assembly including a mask including a sensor area including at least one half-etched area, at least one first deposition area disposed external to the sensor area, and at least one second deposition area disposed in the sensor area, and a mask frame including a global opening. The global opening overlaps each of the first deposition area, the half-etched area, and the second deposition area.

Each of the first and the second deposition areas may include an opening. Each opening of the first and the second deposition areas may include a first etched area formed by etching the mask in a direction from a first surface of the mask toward a second surface of the mask, and a second etched area formed by etching the mask in a direction from the second surface of the mask toward the first surface of the mask.

The half-etched area may include the second etched area.

The mask may extend in a first direction and include a first portion, a second portion, and a third portion that may be successively disposed. The first portion may include a notch recessed by a depth in the first direction. The second portion may be coupled to the mask frame. The third portion may include multiple unit panel manufacturing areas. Each of the plurality of unit panel manufacturing areas may include the sensor area, the first deposition area, and the second deposition area.

The sensor area may include a first sensor area having a circular ring-type shape; and a second sensor area having a pill-like ring-type shape.

The surface area of the second sensor area may be greater than the surface area of the first sensor area.

The number of openings disposed in the second sensor area may be greater than the number of openings disposed in the first sensor area.

An embodiment of the disclosure provides a display panel manufacturing apparatus, including a chamber, a deposition source disposed in the chamber that supplies a deposition material into the chamber, a support that couples to a substrate on which the deposition material is to be deposited, and a mask assembly overlapping the deposition source and comprising a mask including a sensor area including at least one half-etched area, at least one first deposition area disposed external to the sensor area, and at least one second deposition area disposed in the sensor area.

The deposition material may include an organic light emitting material.

The substrate may include a pixel circuit layer including at least one thin film transistor.

An embodiment of the disclosure provides a method of manufacturing a display device, including forming a pixel circuit layer including at least one thin film transistor on a base substrate, disposing a mask assembly to overlap the pixel circuit layer, the mask assembly comprising a mask including a sensor area including at least one half-etched area, at least one first deposition area disposed external to the sensor area, and at least one second deposition area disposed in the sensor area, forming at least one light emitting element by depositing using the mask assembly a deposition material on the pixel circuit layer.

The method may further include setting a trim line in the base substrate in an area corresponding to the sensor area, and forming a light receiving area by removing at least a portion of the base substrate along the set trim line.

One of the at least one light emitting element may be formed external to the trim line at a position adjacent to the trim line may be formed in a dummy pixel that may not be electrically connected to the thin film transistor.

The light emitting element of the dummy pixel may include a hole.

One of the least one light emitting element that may be disposed inside the trim line may be electrically connected to the thin film transistor.

### BRIEF DESCRIPTION OF THE DRAWINGS

An additional appreciation according to the embodiments of the disclosure will become more apparent by describing in detail the embodiments thereof with reference to the accompanying drawings, wherein
FIG. 1 is a schematic diagram illustrating a display panel manufacturing device in accordance with embodiments of the disclosure;
FIG. 2 illustrates a mask assembly in accordance with embodiments of the disclosure;
FIG. 3 illustrates a mask in accordance with embodiments of the disclosure;
FIG. 4 is a schematic diagram illustrating in more detail a display panel manufacturing area in the mask in accordance with embodiments of the disclosure;
FIG. 5A is a partially enlarged view of the display panel manufacturing area of FIG. 4;
FIG. 5B is a sectional view illustrating the mask taken along line I-I' of FIG. 5A;
FIG. 6 is a schematic diagram illustrating in more detail the display panel manufacturing area in the mask in accordance with embodiments of the disclosure;
FIG. 7 is a schematic diagram illustrating the degree of deformation of the mask in case that tensile force may be applied to the mask in accordance with an embodiment in which a second deposition area may not be in a sensor area;
FIG. 8 is a schematic diagram illustrating the degree of deformation of the mask in case that tensile force may be applied to the mask in accordance with an embodiment in which the second deposition area may be positioned in the sensor area;
FIG. 9A is a schematic diagram illustrating a trim line set in the display panel in accordance with embodiments of the disclosure;
FIG. 9B is a schematic diagram illustrating the display panel of FIG. 9A from which a portion thereof has been removed along the trim line;
FIG. 10 is a partially enlarged view of the display panel of FIG. 9B;
FIG. 11 is a schematic diagram showing a sectional view of the display panel of FIG. 10 taken along line II-II', and further showing a light receiving device; and
FIGS. 12A and 12B are partially enlarged views of the mask in accordance with embodiments of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details. Here, various embodiments do not have to be exclusive nor limit the disclosure. For example, specific shapes, configurations, and characteristics of an embodiment may be used or implemented in an embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be predisposed differently from the described order. For example, two consecutively described processes may be predisposed substantially at the same time or predisposed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Also, when an element is referred to as being "in contact" or "contacted" or the like to another element, the element may be in "electrical contact" or in "physical contact" with another element; or in "indirect contact" or in "direct contact" with another element. Further, the X-axis, the Y-axis, and the Z-axis may not be limited to three axes of a rectangular coordinate system, such as the x, y, and z axes, and may be interpreted in a broader sense. For example, the X-axis, the Y-axis, and the Z-axis may be perpendicular to one another, or may be different directions that may not be perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items. A description that a component is "configured to" perform a specified operation may be defined as a case where the component is constructed and arranged with structural features that can cause the component to perform the specified operation.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, may not be necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be disposed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, portion, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein. Hereinafter, embodiments of the disclosure will be described in detail with reference to the accompanying drawings.

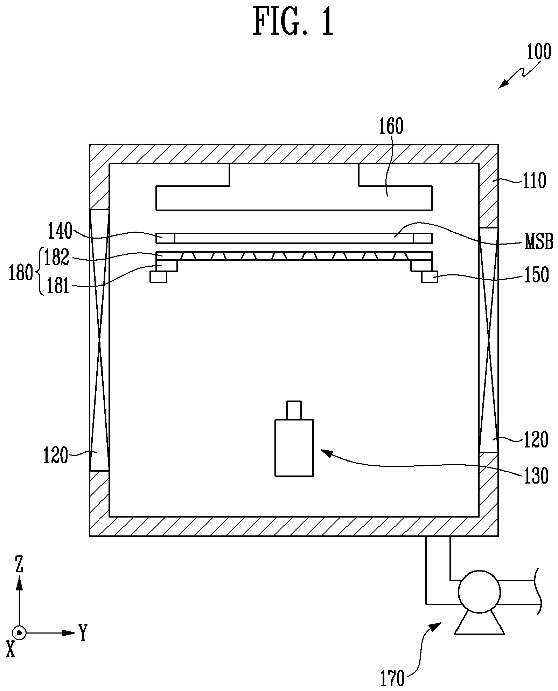

FIG. 1 is a schematic diagram illustrating a display panel manufacturing device 100 in accordance with embodiments of the disclosure. Referring to FIG. 1, the display panel manufacturing device 100 in accordance with embodiments of the disclosure may include a chamber 110, an opening-and-closing component 120, a deposition source 130, a first support 140, a second support 150, a magnetic force generator 160, a pressure controller 170, a mask assembly 180, and the like.

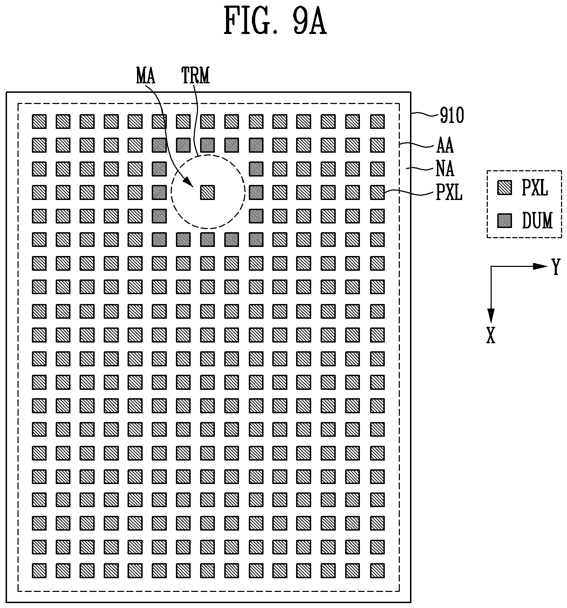

The chamber 110 may have space therein. The internal space of the chamber 110 may function as operating space provided to perform a deposition process. An object, which may be a target for deposition, may be received (or disposed, or seated) in the chamber 110. For example, a substrate MSB (or a mother board MSB) may be disposed in the chamber 110. The substrate MSB may be a portion of a display panel 910 provided during a process of manufacturing the display panel 910 to be described below with reference to FIGS. 9A to 11. Although the following description will be made under the assumption that the target for the deposition may be the substrate MSB, embodiments of the disclosure may not be limited thereto.

The opening-and-closing component 120 may be disposed on one side of the chamber 110. The substrate MSB may be inserted into or drawn out of the internal space of the chamber 110 through the open opening-and-closing component 120. The opening-and-closing component 120 may include a valve or the like. The opening-and-closing component 120 may selectively open or close under a control.

The deposition source 130 may be disposed in the chamber 110. The deposition source 130 may store a deposition material therein, and supply the stored deposition material to the internal space of the chamber 110. The deposition material may include material for forming a pattern layer (e.g., an emission layer) on the substrate MSB. The deposition source 130 may evaporate or sublimate the deposition material by applying energy (e.g., thermal energy, light energy, vibrational energy, or the like) to the deposition material. For example, the deposition source 130 may include a heater therein, and may melt or sublimate the deposition material by heating the deposition material in the deposition source 130 through operation of the heater. The deposition source 130 may be replaceable. The deposition source 130 may be replaced with a new deposition source in the case where the stored deposition material may be exhausted.

The first support 140 may support the substrate MSB. For example, the substrate MSB may be seated on the first support 140 so that the first support 140 can support the substrate MSB. For example, the first support 140 may support the substrate MSB in such a way that the substrate MSB may be adsorbed or attached to the first support 140. For example, the first support 140 may include a clamp to grasp the substrate MSB. For instance, the first support 140 may include a sticky chuck or an electrostatic chuck. The first support 140 may be readily formed with the magnetic force generator 160. The first support 140 may adjust the position of the substrate MSB. For example, the first support 140 may include a UVW stage.

The second support 150 may support the mask assembly 180. The second support 150 may be configured in a manner identical or similar to the foregoing embodiment of the first support 140. The second support 150 may include a frame connected in the chamber 110. The mask assembly 180 may be seated on the frame of the second support 150, and may be supported by the second support 150.

At least one of the first support 140 and the second support 150 may move upward or downward (e.g., ascend and/or descend) in the chamber 110. A distance between the substrate MSB and the mask assembly 180 may be adjusted by the at least one of the first support 140 and the second support 150.

The magnetic force generator 160 may be disposed in the chamber 110. The magnetic force generator 160 may make the mask assembly 180 close to (e.g., bring the mask assembly 180 into close contact with) the substrate MSB. The magnetic force generator 160 may include an electromagnet, a permanent magnet, or the like, configured to generate magnetic force.

The pressure controller 170 may be connected to the chamber 110 to adjust the pressure in the chamber 110. The pressure controller 170 may include a pipe coupled to the chamber 110, a pump disposed on the pipe, etc.

Although not illustrated, the display panel manufacturing device 100 may further include a vision component (not illustrated). The vision component may be disposed inside or outside the chamber 110, and may capture an image related to the positions of the mask assembly 180 and the substrate MSB. The vision component may capture an image of an alignment mark of at least one of the mask assembly 180 and the substrate MSB.

The mask assembly 180 may be disposed between the substrate MSB and the deposition source 130. The mask assembly 180 may include a mask frame 181 and a mask 182. The mask 182 may be fastened to the mask frame 181, with tensile force applied to the mask 182. The mask 182 may include at least one or more openings.

The display panel manufacturing apparatus 100 may be operated as follows. The pressure controller 170 may open the opening-and-closing component 120 while the pressure in the chamber 110 remains identical or similar to the atmospheric pressure. The substrate MSB and the mask assembly 180 may be inserted into the chamber 110 through the open opening-and-closing component 120. For example, at least one of the substrate MSB and the mask assembly 180 may be moved by a separate robot arm disposed outside the chamber 110. For example, at least one of the substrate MSB and the mask assembly 180 may be moved by a shuttle or the like, which may be inserted into or drawn out of the chamber 110.

The substrate MSB may be disposed on the first support 140. The mask assembly 180 may be disposed on the second support 150. The positions of the mask assembly 180 and the substrate MSB may be adjusted within a precise range, based on an image obtained from the vision component (not illustrated), so that the mask assembly 180 and the substrate MSB can be aligned. The substrate MSB and the mask assembly 180 may be moved adjacent to each other. The mask assembly 180 and the substrate MSB may be brought into close contact with each other by the magnetic force generator 160.

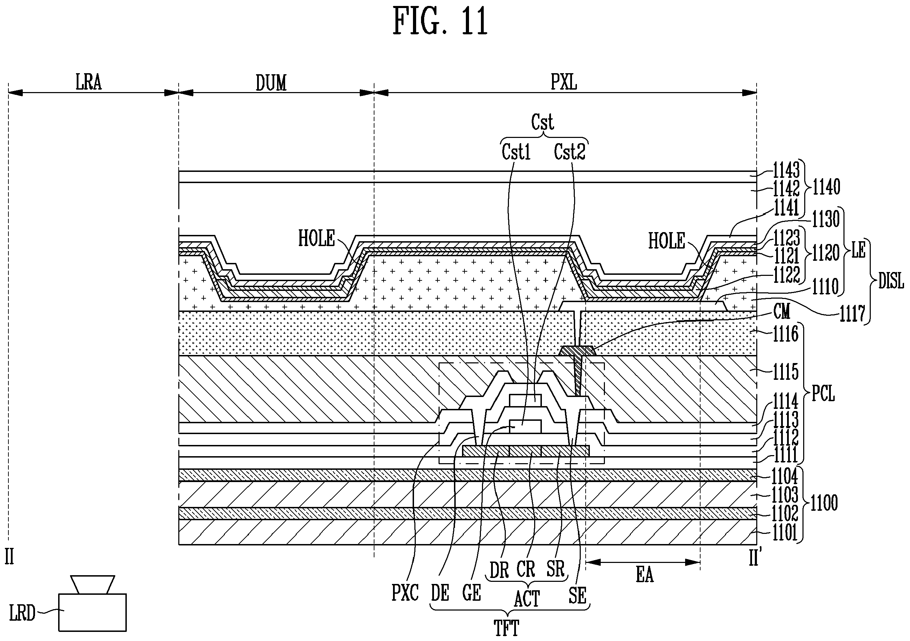

The deposition material may be discharged from the deposition source 130. The discharged deposition material may be deposited on the substrate MSB through the openings provided in the mask 182 of the mask assembly 180. For example, the deposition material deposited on the substrate MSB may form an organic layer such as an emission layer 1122 (refer to FIG. 11) to be described below with reference to FIG. 11. If the foregoing operations have been completed, the substrate MSB may be transferred out of the chamber 110 or moved to another place in the chamber 110 so that another layer can be formed on the substrate MSB.

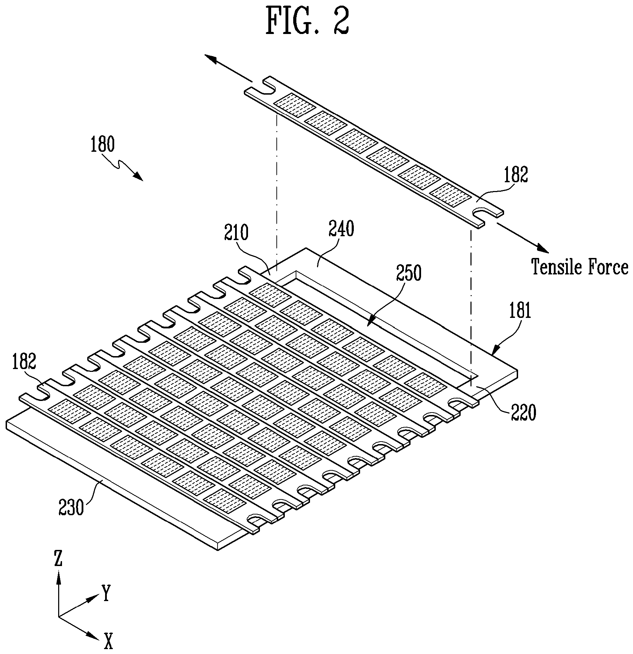

FIG. 2 illustrates the mask assembly 180 in accordance with embodiments of the disclosure. The mask frame 181 may include a global opening 250 through which the deposition material can pass, and may include multiple sub-frames which form the global opening 250. The mask frame 181 may have a rectangular frame shape. For example, the mask frame 181 may include a first sub-frame 210, a second sub-frame 220, a third sub-frame 230, and a fourth sub-frame 240, forming in particular a rectangular frame. For example, the first sub-frame 210 and the second sub-frame 220 may be spaced apart from each other in an X-axis direction, which may be a longitudinal direction of the mask 182, and may extend in a Y-axis direction, which may be a direction (e.g., a transversal direction) intersecting the longitudinal direction of the mask 182. The third sub-frame 230 and the fourth sub-frame 240 may be spaced apart from each other in the Y-axis direction, and may extend in the X-axis direction. The first sub-frame 210 may be connected to the third sub-frame 230 and the fourth sub-frame 240. The second sub-frame 220 may be connected to the third sub-frame 230 and the fourth sub-frame 240.

As illustrated in FIG. 2, the mask frame 181 may have a rectangular shape in a plan view. However, the embodiments of the disclosure may not be limited to the foregoing. For example, the mask frame 181 may have various shapes such as a triangular shape, a polygonal shape, e.g., a pentagonal shape or the like, a circular shape, and an elliptical shape. As illustrated in FIG. 2, the global opening 250 may have a rectangular shape in a plan view. However, the embodiments of the disclosure may not be limited to the foregoing. For example, the global opening 250 may have various shapes such as a triangular shape, a polygonal shape, e.g., a pentagonal shape or the like, a circular shape, and an elliptical shape.

The thickness of the mask frame 181 may be very small compared to an X-directional length or a Y-directional length. If the thickness of the mask frame 181 is excessively large, the passing of the deposition material through the mask 182 during the deposition process using the mask assembly 180 may be limited. On the other hand, if the thickness of the mask frame 181 is excessively small, it may be difficult to secure the strength of the mask frame 181 for supporting the mask 182. Therefore, the mask frame 181 may have an appropriate thickness, taking into account the foregoing points.

The mask frame 181 may be formed of metal. For example, the mask frame 181 may be formed of metal that may not be excessively deformed by welding.

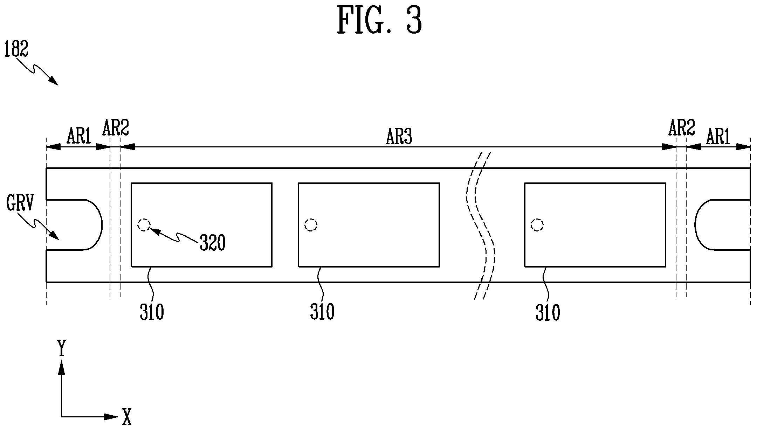

In an embodiment, the mask frame 181 may further include a support stick (not illustrated). The support stick may overlap the mask 182 in an area other than a display panel manufacturing area 310 of the mask 182 which will be described with reference to FIG. 3. For example, the support stick may extend in the Y-axis direction and be connected to the third sub-frame 230 and/or the fourth sub-frame 240. The support stick may function to block the deposition material in some areas so that the deposition material can be deposited only in a preset area (e.g., the display panel manufacturing area 310). The support stick may function to support the mask 182. The support stick may mitigate a phenomenon in which the mask 182 may be bent by magnetic force.

The mask frame 181 may support the mask 182. For example, the mask 182 may be fastened to the mask frame 181 while being tensioned in the X-axis direction (e.g., the longitudinal direction).

The mask 182 may have a longitudinal shape. A plurality of masks 182 may be placed in parallel to each other, and in particular at and/or above the mask frame181. A first portion AR1, see FIG. 3, at opposite ends of the mask 182 may be overlap the mask frame 181, in particular at the first sub-frame 210 and the second sub-frame 220.

The mask 182 may be formed of, for example, stainless steel, invar, nickel (Ni), cobalt (Co), a nickel alloy, a nickel-cobalt alloy, or a combination thereof. The foregoing materials have relatively low expansion coefficients. Hence, a phenomenon in which the mask 182 may be deformed by heat during the process of manufacturing the mask assembly 180 may be mitigated.

The width (e.g., the Y-directional length) of the mask 182 may be less than the width (e.g., the Y-directional length) of the global opening 250. The mask 182 may comprise multiple masks. In other words, a plurality of masks 182 may be provided do cover the global opening 250. The masks 182 may be successively arranged between the third sub-frame 230 and the fourth sub-frame 240. Each mask 182 may be welded and fixed to the first sub-frame 210 and the second sub-frame 220. The masks 182 may cover the global opening 250.

FIG. 3 illustrates the mask 182 in accordance with embodiments of the disclosure. Referring to FIG. 3, the mask 182 in accordance with embodiments of the disclosure may include a first portion AR1, a second portion AR2, and a third portion AR3, which may be successively positioned in the X-axis direction (e.g., the longitudinal direction).

The first portion AR1 may be positioned at each of the opposite ends of the mask 182 in the X-axis direction. The first portion AR1 may be an area which may be grasped by a clamp or the like so that the mask 182 can be tensioned. A notch GRV may be formed in the first portion AR1 to make it easy for the mask 182 to be grasped by the clamp or the like. The notch GRV may be formed by recessing the end of the mask 182 by a certain depth in one direction (e.g., the X-axis direction). The first portion AR1 may be cut off and removed from the mask 182 after the mask 182 is fixed to the mask frame 181.

The second portion AR2 may be positioned between the first portion AR1 and the third portion AR3, and may be an area in which the mask 182 and the mask frame 181 may be connected to each other. For example, the second portion AR2 may be welded and fixed to the first sub-frame 210 or the second sub-frame 220 of the mask frame 181.

The third portion AR3 may be positioned in an intermediate portion of the mask 182, and may overlap the above-mentioned global opening 250 (refer to FIG. 2). One or more display panel manufacturing areas 310 may be positioned in the third portion AR3. Referring to FIG. 3, multiple display panel manufacturing areas 310 may be successively disposed in a line in the X-axis direction (e.g., the longitudinal direction) in the third portion AR3.

One or more openings may be positioned in the display panel manufacturing area 310. The deposition material may be deposited on the substrate MSB (refer to FIG. 1) through the openings.

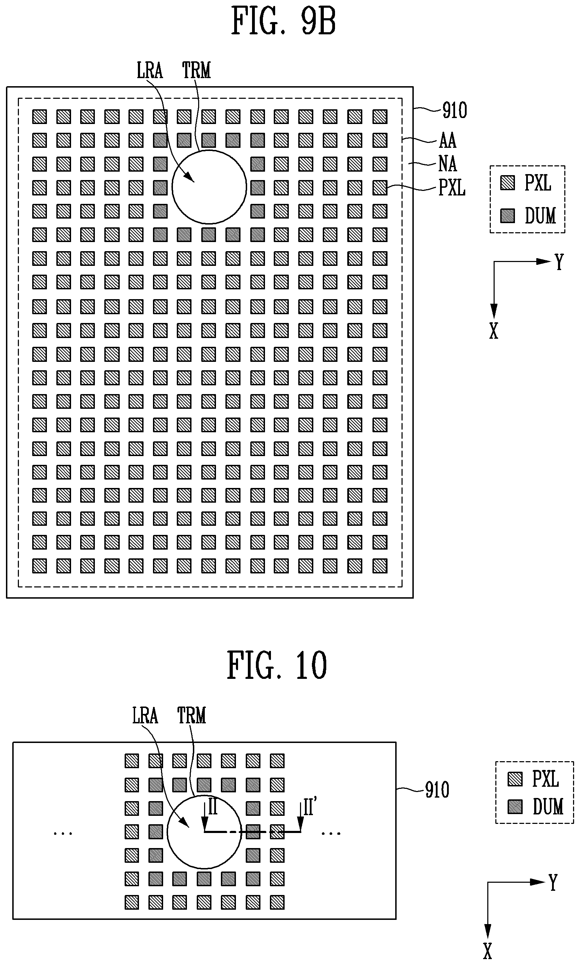

A sensor area 320 in which no opening may be formed may be positioned in the display panel manufacturing area 310. The reason why the sensor area 320 may be provided in the mask 182 may be for preventing the deposition material from being deposited on at least some areas of the display panel (e.g., the display panel 910 described with reference to FIGS. 9A to 11) in accordance with embodiments of the disclosure. Hence, during a process of cutting off and removing at least a portion (e.g., an inside area of a trim line TRM of FIG. 9A) of the display panel using a laser or the like, a defect may be prevented (or mitigated) from occurring due to foreign material (e.g., foreign material generated during cutting off the deposition material). The foregoing operation will be described with reference to FIGS. 9A and 9B.

To reduce (for example, minimize) a deviation between tensile forces applied to the sensor area 320 and a remaining area (e.g., a peripheral portion of the opening) of the mask 182, a half-etched area formed by removing one surface of the mask 182 to a certain depth may be provided in the sensor area 320. However, it may be difficult to completely remove a difference in tensile force between a peripheral portion of the sensor area 320 and the remaining area (e.g., the peripheral portion of the opening) of the mask 182 in a deposition operation in which high precision may be needed. Due to a difference in tensile force, the mask 182 may be undesirably deformed, thus resulting in a defect in quality of deposition. Therefore, there may be a need to reduce (e.g., minimize) the surface area of the sensor area 320.

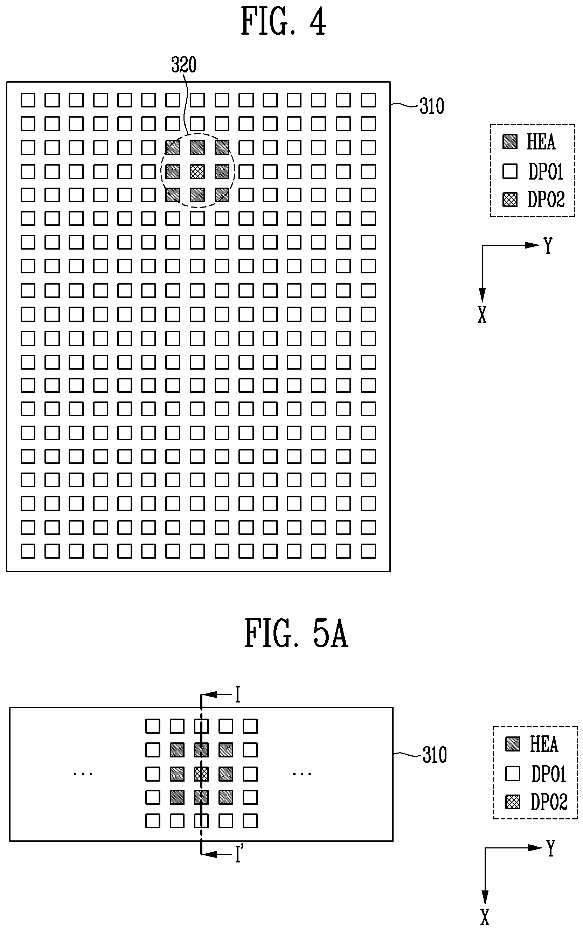

FIG. 4 is a schematic diagram illustrating in more detail the display panel manufacturing area 310 in the mask 182 in accordance with embodiments of the disclosure. Referring to FIG. 4, the display panel manufacturing area 310 in accordance with embodiments of the disclosure may include a half-etched area HEA, a first deposition area DPO1, and a second deposition area DPO2. The half-etched area HEA may be disposed in the sensor area 320. The sensor area 320 may include one or more half-etched areas HEA. The first deposition area DPO1 may be positioned outside the sensor area 320. The first deposition area DPO1 may include an opening. The second deposition area DPO2 may be positioned inside the sensor area 320. For example, the second deposition area DPO2 may be positioned to be enclosed by the sensor area 320. The second deposition area DPO2 may include an opening. The second deposition area DPO2 may function to minimize the surface area of the sensor area 320 (e.g., the surface area of the half-etched areas HEA) in the display panel manufacturing area 310.

The sensor area 320 may be a circular area. The first deposition area DPO1, the second deposition area DPO2 and /or the half-etched areas HEA may have a rectangular shape. The half-etched areas HEA may be placed partly in the sensor area 320 and partly outside the sensor area 320.

Referring to FIG. 4, the first deposition areas DPO1 may be disposed at positions spaced apart from each other, in particular by a regular distance. A distance between the first deposition areas DPO1 adjacent to each other (e.g., adjacent to each other in the X-axis direction or the Y-axis direction) may be the same (or substantially the same) as a distance between the first deposition area DPO1 and the half-etched area HEA that may be adjacent to each other. The distance between the first deposition areas DPO1 adjacent to each other may be the same (or substantially the same) as a distance between the half-etched area HEA and the second deposition area DPO2 that may be adjacent to each other.

The first deposition area DPO1 of the display panel manufacturing area 310 may correspond to a pixel PXL or a dummy pixel DUM in the display panel (e.g., the display panel 910 illustrated in FIG. 9A). The second deposition area DPO2 of the display panel manufacturing area 310 may correspond to the pixel PXL in the display panel (e.g., the display panel 910 illustrated in FIG. 9A).

The sensor area 320 may be formed to have a ring-type shape. Two or more half-etched areas HEA may be disposed in a ring shape in the display panel manufacturing area 310. The shape of the sensor area 320 may be a circular shape or a polygonal shape. The shape of the sensor area 320 may be a pill-like shape (e.g., a shape having a side extending in the Y-axis direction).

Although the sensor area 320 may be positioned in a central area of the display panel manufacturing area 310, embodiments of the disclosure may not be limited thereto. The sensor area 320 may instead be positioned in an area biased to one side (e.g., in the Y-axis direction) in the central area.

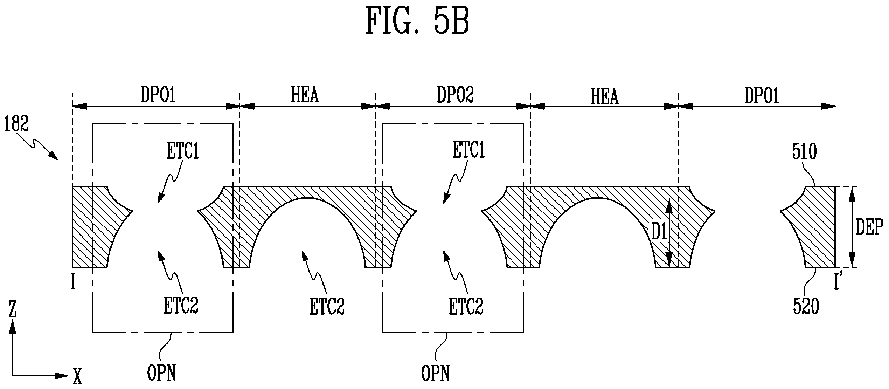

FIG. 5A is a partially enlarged view of the display panel manufacturing area 310 of FIG. 4. FIG. 5B is a sectional view illustrating the mask 182 taken along line I-I' of FIG. 5A. FIG. 5A illustrates the second deposition area DPO2, the half-etched areas HEA positioned around the second deposition area DPO2, and the first deposition areas DPO1 positioned around the half-etched areas HEA.

FIG. 5B is a sectional view illustrating the mask 182 taken along line I-I' of FIG. 5A, and is a sectional view of the mask 182 taken in the X-axis direction. Referring to FIG. 5B, the first deposition area DPO1 and the second deposition area DPO2 each may include an opening OPN.

The opening OPN may include a first etched area ETC1 and a second etched area ETC2. The first etched area ETC1 may be formed by etching a first surface 510 (e.g., an upper surface 510) of the mask 182 to a certain depth (for example, by etching the first surface 510 to a certain depth in a -Z-axis direction). The second etched area ETC2 may be formed by etching a second surface 520 (e.g., a lower surface 520) of the mask 182 to a certain depth (for example, by etching the second surface 520 to a certain depth in a + Z-axis direction). The first surface 510 and the second surface 520 may face each other. Each of the first etched area ETC1 and the second etched area ETC2 may have a tapered inclined surface.

In contrast with opening OPN, the half-etched area HEA may include a second etched area ETC2 (e.g., only the second etched area ETC2). A depth D1 of the second etched area ETC2 may be unrestrictedly determined within a range in which the depth D1 does not exceed a thickness DEP of the mask 182. For example, the depth D1 of the second etched area ETC2 does not exceed the thickness DEP of the mask 182, and may be greater than or equal to a half of the thickness DEP of the mask 182. For example, if the thickness DEP of the mask 182 may be an approximately 20 µm, the depth D1 of the second etched area ETC2 may be approximately 10 µm or more and approximately 20 µm or less. Hence, in case that tensile force is applied to the mask 182 (e.g., tensile force may be applied in the X-axis direction), a deviation in tensile force between the peripheral portion of the half-etched area HEA and the peripheral portion of the opening OPN may be reduced. In other words, the tensile force over the overall area of the mask 182 may be uniform, so that the quality of the deposition can be satisfactory (or uniform). In an embodiment, the depth D1 of the second etched area ETC2 may instead be equal to or less than the half of the thickness DEP of the mask 182.

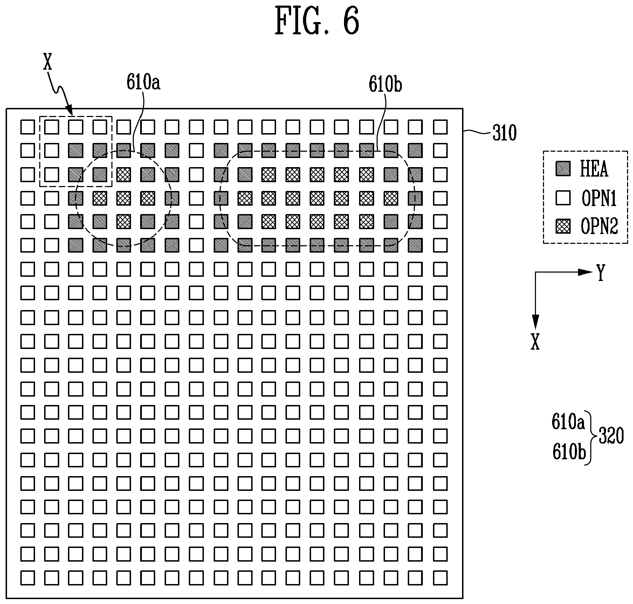

FIG. 6 is a schematic diagram illustrating in more detail the display panel manufacturing area 310 in the mask in accordance with embodiments of the disclosure. Referring to FIG. 6, in the display panel manufacturing area 310 in accordance with embodiments of the disclosure, the sensor area 320 may include a first sensor area 610a and a second sensor area 610b. The first sensor area 610a may be a circular ring-type sensor area. The second sensor area 610b may be a pill-like ring-type sensor area. The first sensor area 610a may be formed of one or more half-etched areas HEA. The second sensor area 610b may be formed of one or more half-etched areas HEA. The second sensor area 610b may have an elliptical shape, in particular an rectangular shape with rounded edges.

The first sensor area 610a and the second sensor area 610b may be spaced apart from each other. For example, one or more first deposition areas DPO1 may be positioned between the first sensor area 610a and the second sensor area 610b. For example, the first sensor area 610a and the second sensor area 610b may be spaced apart from each other in the Y-axis (or the X-axis) direction. The first sensor area 610a and the second sensor area 610b may differ in surface area from each other. For example, the surface area of the second sensor area 610b may be greater than that of the first sensor area 610a. The number of openings disposed in the first sensor area 610a (or the number of second deposition areas DPO2) may differ from the number of openings disposed in the second sensor area 610b (or the number of second deposition areas DPO2). For example, the number of openings disposed in the second sensor area 610b may be greater than the number of openings disposed in the first sensor area 610a.

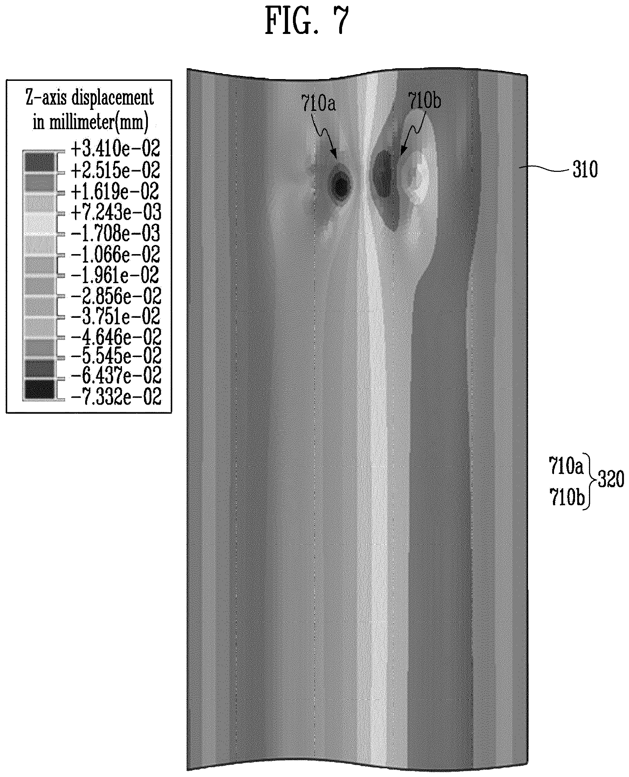

FIG. 7 is a schematic diagram illustrating the degree of deformation of the mask in case that tensile force is applied to the mask in accordance with an embodiment in which the second deposition area is not present in the sensor area 320.

Generally, the mask has a thickness which may be very small compared to the length and/or the width thereof. For such a reason, if the mask is tensioned in one direction (e.g., the ± X-axis direction; refer to FIG. 2), unintended wrinkles may be formed in the mask by stress in the mask. Due to the wrinkles formed in the mask, the mask may be partially deformed in a thickness direction (e.g., a ± Z-axis direction) perpendicular to a tensile direction. The wrinkles formed in the mask may impede close contact between the mask and the mask frame. Due to the wrinkles formed in the mask, the quality of the deposition may be deteriorated. An embodiment illustrated in FIG. 7 may be a comparative example to the embodiments of the disclosure.

Referring to FIG. 7, the sensor area 320 may include a third sensor area 710a and a fourth sensor area 710b. The third sensor area 710a may correspond to the first sensor area 610a described above with reference to FIG. 6. The fourth sensor area 710b may correspond to the second sensor area 610b described above with reference to FIG. 6. However, the third sensor area 710a may instead be different from the first sensor area 610a illustrated in FIG. 6 in that there may be no opening in the third sensor area 710a. Likewise, the fourth sensor area 710b may be different from the second sensor area 610b illustrated in FIG. 6 in that there may be no opening in the fourth sensor area 710b.

In the mask illustrated in FIG. 7, the maximum displacement based on the Z-axis may be approximately +34.10 µm, and the minimum displacement may be approximately -73.32 µm, so that the maximum difference in displacement (i.e., the size of a wrinkle) may be approximately 107 µm.

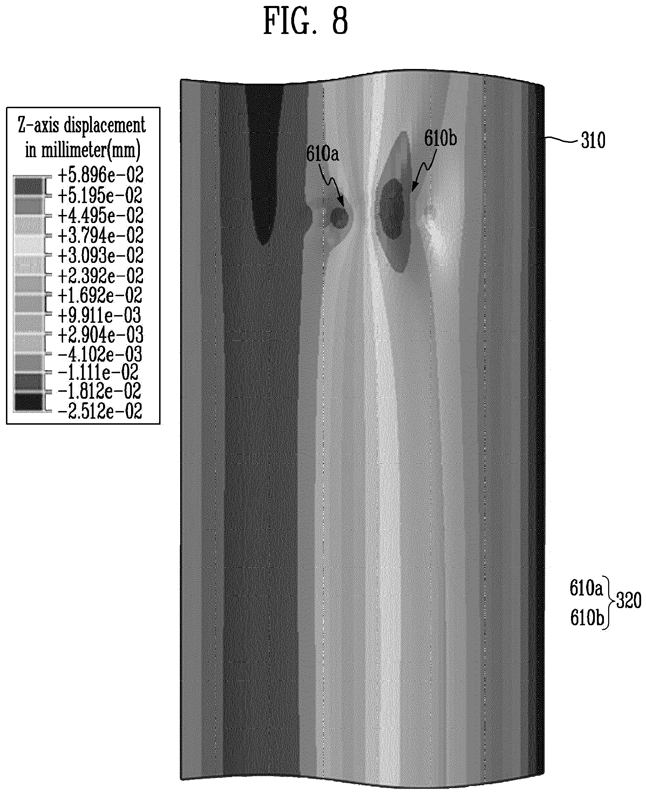

FIG. 8 is a schematic diagram illustrating the degree of deformation of the mask in case that tensile force may be applied to the mask in accordance with an embodiment in which the second deposition area may be positioned in the sensor area. FIG. 8 illustrates the mask 182 (refer to FIG. 1) including the first sensor area 610a and the second sensor area 620a in accordance with embodiments of the disclosure.

In the mask 182 illustrated in FIG. 8, the maximum displacement based on the Z-axis may be approximately +58.96 µm, and the minimum displacement may be approximately - 25.12 µm, so that the maximum difference in displacement (i.e., the size of a wrinkle) may be approximately 84 µm.

In the mask 182 in accordance with embodiments of the disclosure, the maximum difference in displacement may be reduced by approximately 20%, compared to that of the mask illustrated in the comparative example of FIG. 7. Therefore, the mask 182 in accordance with embodiments of the disclosure may come into closer contact with the mask frame 181 (refer to FIG. 1).

FIG. 9A is a schematic diagram illustrating a trim line TRM set in the display panel 910 in accordance with embodiments of the disclosure. The display panel 910 in accordance with embodiments of the disclosure may correspond to the display panel manufacturing area 310 (refer to FIG. 3) of the mask 182 (refer to FIG. 1) described above. The display panel 910 in accordance with embodiments of the disclosure may include at least a portion of the substrate MSB (refer to FIG. 1) described above.

Referring to FIG. 9A, the display panel 910 may include a display area AA and a non-display area NA. Multiple pixels PXL may be disposed in the display area AA. Each of the pixels PXL may include a light emitting element. The light emitting element may include an emission layer formed of the above-mentioned deposition material.

One or more dummy pixels DUM may be disposed in the display area AA. The dummy pixel DUM may include a light emitting element which may not be electrically connected to a thin-film transistor. The dummy pixel DUM may be positioned around the trim line TRM (e.g., in an area adjacent to the trim line TRM). Taking into account an error of a process of cutting off and removing a portion of the display panel 910 along the trim line TRM, the dummy pixel DUM may be designed to prevent an image from being displayed in the area adjacent to the trim line TRM. Furthermore, each of the dummy pixels DUM may be formed to include an emission layer, so that the surface area of the above-mentioned sensor area 320 (refer to FIG. 3) can be reduced (for example, minimized).

The non-display area NA may be positioned around the display area AA. For example, the non-display area NA may be positioned in a periphery of the display area AA. Pins (e.g., pads) provided to apply signals (e.g., voltages) to the pixels PXL may be formed in the non-display area NA. After at least a portion of the display panel 910 may be removed along the trim line TRM, an area inside the trim line TRM may become a non-display area NA in which an image may not be displayed.

The trim line TRM may be set in the display area AA. At least a portion of the display panel 910 that may be positioned inside the set trim line TRM may be removed along the trim line TRM. For example, a laser may be irradiated along the trim line TRM, so that at least a portion of the display panel 910 may be cut off and removed.

The area inside the trim line TRM may be a magnetic force application area MA. For example, metal material may be located in the area inside the trim line TRM. For example, a thin-film transistor may be formed inside the trim line TRM. For example, a light emitting element formed inside the trim line TRM may be electrically connected to the thin-film transistor. The magnetic force application area MA may be designed to make it possible for the mask 182 (refer to FIG. 1) and the substrate MSB (refer to FIG. 1) to come into closer contact with each other around the trim line TRM. The quality of the deposition may be improved by the magnetic force application area MA.

FIG. 9B is a schematic diagram illustrating the display panel 910 of FIG. 9A from which a portion thereof has been removed along the trim line TRM. Referring to FIG. 9B, a portion of the display panel 910 that may be positioned inside the trim line TRM may be cut off and removed along the trim line TRM. The trim line TRM may have a circular shape as illustrated in FIG. 9B, but may not be limited thereto. For example, the trim line TRM may instead have a pill-like shape (e.g., similar to the shape of the second sensor area 610b illustrated in FIG. 6), or may have other polygonal shapes.

The area formed by removing the portion of the display panel 910 inside the trim line TRM may function as a light receiving area LRA. The light receiving area LRA may be formed to allow external incident light to pass therethrough. In the display device including the display panel 910 in accordance with embodiments of the disclosure, a light receiving device (not illustrated) (e.g., an image capturing device such as a camera (or an image sensor), a sensor such as a proximity sensor or an illuminance sensor, or the like) may be disposed to overlap the a dummy pixel LRA.

FIG. 10 is a partially enlarged view of the display panel 910 of FIG. 9B. Referring to FIG. 10, there may be illustrated the trim line TRM, the dummy pixels DUM positioned adjacent to the trim line TRM, and the pixels PXL positioned adjacent to the dummy pixels DUM. Although referring to FIG. 10 there may be illustrated the case where one dummy pixel DUM may be disposed between the trim line TRM and each pixel PXL, embodiments of the disclosure may not be limited thereto. For example, two or more dummy pixels DUM may be disposed between the trim line TRM and each pixel PXL.

FIG. 11 is a schematic diagram showing a sectional view of the display panel 910 of FIG. 10 taken along line II-II', and further showing the light receiving device LRD. The sectional view taken along line II-II' shows schematic cross-sections of the light receiving device LRD, the dummy pixel DUM, and the pixel PXL. The following description will be made based on the sectional view of the pixel PXL illustrated in FIGS. 10 and 11.

Referring to FIGS. 10 and 11, the display panel 910 may include a stacked structure having a base substrate 1100, a pixel circuit layer PCL, a display layer DISL, and an encapsulation layer 1140. For example, the base substrate 1100 may include a base layer including polymer resin, and a barrier layer formed of an inorganic insulating layer.

For example, the base substrate 1100 may include a first base layer 1101, a first barrier layer 1102, a second base layer 1103, a second barrier layer 1104, and the like, which may be successively stacked on each other. The first base layer 1101 and the second base layer 1103 each may include polyimide (PI), polyethersulfone (PES), polyarylate, polyetherimide (PEI), polyethyelenene naphthalate (PEN), polyethyeleneterepthalate (PET), polyphenylene sulfide (PPS), polycarbonate (PC), cellulose triacetate (CTA), and/or cellulose acetate propionate (CAP), the like, or a combination thereof. The first barrier layer 1102 and the second barrier layer 1104 may include organic insulating material such as silicon oxide, silicon oxynitride, and/or silicon nitride. The base substrate 1100 may have characteristics of flexibility.

The pixel circuit layer PCL may be disposed on the base substrate 1100. The pixel circuit layer PCL may include a pixel circuit PXC. FIG. 11 illustrates a schematic cross-section of a portion of the pixel circuit PXC, as an example. The pixel circuit PXC may include at least one thin-film transistor TFT and at least one storage capacitor Cst. The pixel circuit layer PCL may not only include the pixel circuit PXC, but may also include a buffer layer 1111, a first gate insulating layer 1112, a second gate insulating layer 1113, an interlayer insulating layer 1114, a first planarization insulating layer 1115, a second planarization insulating layer 1116, and the like, which may be disposed under and/or over elements that form the pixel circuit PXC.

The buffer layer 1111 may reduce or prevent permeation of foreign material, water, or external air from the bottom of the base substrate 1100. The buffer layer 1111 may provide a planarization surface on the base substrate 1100. The buffer layer 1111 may include inorganic insulating material such as silicon oxide, silicon oxynitride, silicon nitride, or a combination thereof. The buffer layer 1111 may have a single-layer structure or multilayer structure including the foregoing material.

The thin-film transistor TFT may be disposed on the buffer layer 1111. The thin-film transistor may include a semiconductor layer ACT, a gate electrode GE, a drain electrode DE, and a source electrode SE. The semiconductor layer ACT may include polycrystalline silicon. The semiconductor layer ACT may include single-crystal silicon. The semiconductor layer ACT may include amorphous silicon (a-Si). The semiconductor layer ACT may instead include an oxide semiconductor. The semiconductor layer ACT may instead include an organic semiconductor or the like. The semiconductor layer ACT may include a channel area CR, a drain area DR disposed on one side of the channel area CR, and a source area SR disposed on the other side of the channel area CR.

The gate electrode GE may overlap the channel area CR. The gate electrode GE may include low-resistance metal material. The gate electrode GE may include conductive material including molybdenum (Mo), aluminum (Al), copper (Cu), titanium (Ti), the like, or a combination thereof. The gate electrode GE may have a single-layer structure or multilayer structure including the foregoing material.

The first gate insulating layer 1112 may be positioned between the semiconductor layer ACT and the gate electrode GE. The first gate insulating layer 1112 may include inorganic insulating material such as silicon oxide (SiO₂), silicon nitride (SiNₓ) (x may be a positive number greater than 0), silicon oxynitride (SiON), aluminum oxide (Al₂O₃), titanium oxide (TiO₂), tantalum oxide (Ta₂O₅), hafnium oxide (HfO₂), and/or zinc oxide (ZnO₂).

The second gate insulating layer 1113 may be provided to cover the gate electrode GE. The second gate insulating layer 1113 may include inorganic insulating material such as silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), and/or zinc oxide (ZnO₂), in a manner similar to that of the first gate insulating layer 1112.

An upper electrode Cst2 of the storage capacitor Cst may be disposed over the second gate insulating layer 1113. The upper electrode Cst2 may overlap the gate electrode GE disposed thereunder. The gate electrode GE and the upper electrode Cst2 that overlap each other with the second gate insulating layer 1113 disposed therebetween may form the storage capacitor Cst. The gate electrode GE may function as a lower electrode Cst1 of the storage capacitor Cst.

As illustrated in FIG. 11, the storage capacitor Cst may be formed to have a structure overlapping the thin-film transistor TFT. In an embodiment, the storage capacitor Cst may instead be formed to have a structure which does not overlap the thin-film transistor TFT.

The upper electrode Cst2 may include aluminum (Al), platinum (Pt), palladium (Pd), silver (Ag), magnesium (Mg), gold (Au), nickel (Ni), neodymium (Nd), iridium (Ir), chrome (Cr), calcium (Ca), molybdenum (Mo), titanium (Ti), tungsten (W), and/or copper (Cu). The upper electrode Cst2 may have a single layer structure or multilayer structure including the foregoing material.

The interlayer insulating layer 1114 may cover the upper electrode Cst2. The interlayer insulating layer 1114 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), and/or zinc oxide (ZnO₂). The interlayer insulating layer 1114 may include a single layer structure or multilayer structure including the foregoing inorganic insulating material.

The drain electrode DE and the source electrode SE each may be disposed on the interlayer insulating layer 1114. The drain electrode DE and the source electrode SE may be respectively electrically connected to the drain area DR and the source area SR through contact holes formed in the insulating layers provided under the drain electrode DE and the source electrode SE. The drain electrode DE and the source electrode SE may include material having excellent conductivity. For example, each of the drain electrode DE and the source electrode SE may include conductive material including molybdenum (Mo), aluminum (Al), copper (Cu), titanium (Ti), the like, or a combination thereof. Each of the drain electrode DE and the source electrode SE may have a single-layer structure or multilayer structure including the foregoing material. For example, each of the drain electrode DE and the source electrode SE may have a multilayer structure of Ti/Al/Ti.

The first planarization insulating layer 1115 may cover the drain electrode DE and the source electrode SE. A metal contactor CM may be disposed on the first planarization insulating layer 1115. The metal contactor CM may include conductive material including molybdenum (Mo), aluminum (Al), copper (Cu), titanium (Ti), the like or a combination thereof. The metal contactor CM may have a single-layer structure or multilayer structure including the foregoing material. The second planarization insulating layer 1116 may be disposed on the first planarization insulating layer 1115. The second planarization insulating layer 1116 may cover the metal contactor CM.

The first planarization insulating layer 1115 and the second planarization insulating layer 1116 each may include organic insulating material, e.g., a general-purpose polymer such as polymethylmethacrylate (PMMA) or polystyrene (PS), a polymer derivative including a phenolic group, an acrylic polymer, an imide-based polymer, aryl ether-based polymer, amide-based polymer, fluorinate polymer, p-xylene-based polymer, vinyl alcohol-based polymer, and a blend thereof.

The display layer DISL may be disposed on the pixel circuit layer PCL having the foregoing structure. The light emitting element LE may be disposed in the display layer DISL. The light emitting element LE may include an organic light emitting diode (OLED). The light emitting element LE may include a pixel electrode 1110, an intermediate layer 1120, and a counter electrode 1130. The light emitting element LE may emit, for example, red, green, or blue light, or may emit red, green, blue, or white light. The light emitting element LE may emit light from the emission area EA.

The pixel electrode 1110 may be electrically connected to the thin-film transistor through contact holes formed in the second planarization insulating layer 1116 and the first planarization insulating layer 1115. Referring to FIG. 11, the pixel electrode 1110 may be electrically connected to the thin-film transistor through the metal contactor CM disposed on the first planarization insulating layer 1115. The pixel electrode 1110 may include conductive oxide such as indium tin oxide (ITO), indium zinc oxide (IZO), zinc oxide (ZnO), indium oxide (In₂O₃), indium gallium oxide (IGO), aluminum zinc oxide (AZO), or a combination thereof. The pixel electrode 1110 may include a reflective layer including silver (Ag), magnesium (Mg), aluminum (Al), platinum (Pt), palladium (Pd), gold (Au), nickel (Ni), neodymium (Nd), iridium (Ir), chrome (Cr), a compound thereof, or a combination thereof. In an embodiment, the pixel electrode 1110 may further include a layer which may be formed of ITO, IZO, ZnO, In₂O₃, or a combination thereof and may be provided over and/or under the reflective layer.

A pixel defining layer 1117 may be disposed on the pixel electrode 1110. The pixel defining layer 1117 may include a hole HOLE through which at least a portion of an upper surface of the pixel electrode 1110 may be exposed. The pixel defining layer 1117 may include organic insulating material and/or inorganic insulating material. In the pixel PXL, the hole HOLE may define the emission area EA in which light may be emitted from the light emitting element LE. For example, a width of the hole HOLE may correspond to a width of the emission area EA.

The intermediate layer 1120 may include an emission layer 1122 formed to correspond to the pixel electrode 1110. The emission layer 1122 may include high or low molecular organic light emitting material which may emit a color of light. The emission layer 1110 may instead include inorganic light emitting material, or may include quantum dots.

The intermediate layer 1120 may include a first functional layer 1121 and a second functional layer 1123 which may be respectively disposed under and over the emission layer 1122. The first functional layer 1121 may include, for example, a hole transport layer (HTL), a hole injection layer (HIL), and the like. The second functional layer 1123 may include an electron transport layer (ETL), an electron injection layer (EIL), and the like. The first functional layer 1121 and/or the second functional layer 1123 may be a common layer which may be readily formed to cover the entirety of the base substrate 1100 in the same manner as that of the counter electrode 1130 to be described below.

The base substrate 1100, the pixel circuit layer PCL, the metal contactor CM, the pixel electrode 1110, the pixel defining layer 1117, and the first functional layer 1121 may form the above-mentioned substrate MSB (refer to FIG. 1). In an embodiment, the metal contactor CM may be omitted.

The counter electrode 1130 may be disposed on the pixel electrode 1110, and may be disposed to overlap the pixel electrode 1110. The counter electrode 1130 may include conductive material having a low work function. For example, the counter electrode 1130 may include a light transmission layer (e.g., a transparent layer or a translucent layer) including silver (Ag), magnesium (Mg), aluminum (Al), platinum (Pt), palladium (Pd), gold (Au), nickel (Ni), neodymium (Nd), iridium (Ir), chrome (Cr), lithium (Li), calcium (Ca), an alloy thereof, or a combination thereof. The counter electrode 1130 may further include, on the light transmission layer including the foregoing material, a layer formed of ITO, IZO, ZnO, or In₂O₃, or a combination thereof. The counter electrode 1130 may be a common layer which may be readily formed to cover the entirety of the base substrate 1100.

The encapsulation layer 1140 may be disposed on the display layer DISL, and may cover the display layer DISL. The encapsulation layer 1140 may include at least one inorganic encapsulation layer and at least one organic encapsulation layer. For example, the encapsulation layer 1140 may include a first inorganic encapsulation layer 1141, an organic encapsulation layer 1142, and a second inorganic encapsulation layer 1143. The first inorganic encapsulation layer 1141, the organic encapsulation layer 1142, and the second inorganic encapsulation layer 1143 may be successively stacked on each other.

The first inorganic encapsulation layer 1141 and the second inorganic encapsulation layer 1143 each may include one or more inorganic materials among aluminum oxide, titanium oxide, tantalum oxide, hafnium oxide, zinc oxide, silicon oxide, silicon nitride, silicon oxynitride, or a combination thereof. The organic encapsulation layer 1142 may include polymer-based material. The polymer-based material may include acrylic resin, epoxy resin, polyimide, polyethylene, the like, or a combination thereof. For example, the organic encapsulation layer 1142 may include acrylate. The organic encapsulation layer 1142 may be formed by curing a monomer or applying a polymer. The organic encapsulation layer 1142 may have light transmitting properties. Hence, the pixel PXL may emit light.

Referring to FIG. 11, the dummy pixel DUM may include a light emitting element LE. For example, the dummy pixel DUM may include an emission layer 1122. For example, the dummy pixel DUM may include a hole HOLE. The light emitting element LE may include a pixel electrode 1110, an intermediate layer 1120, and a counter electrode 1130. However, the pixel electrode 1110 in the dummy pixel DUM may not be electrically connected to the thin-film transistor. For example, in the dummy pixel DUM, the thin-film transistor may not be formed.

The light receiving area LRA may be formed in an area from which the display panel 910 (refer to FIG. 10) may be removed. The light receiving device LRD may be disposed to overlap at least a portion of the light receiving area LRA. The light receiving device LRD may include a camera, a sensor, or the like.

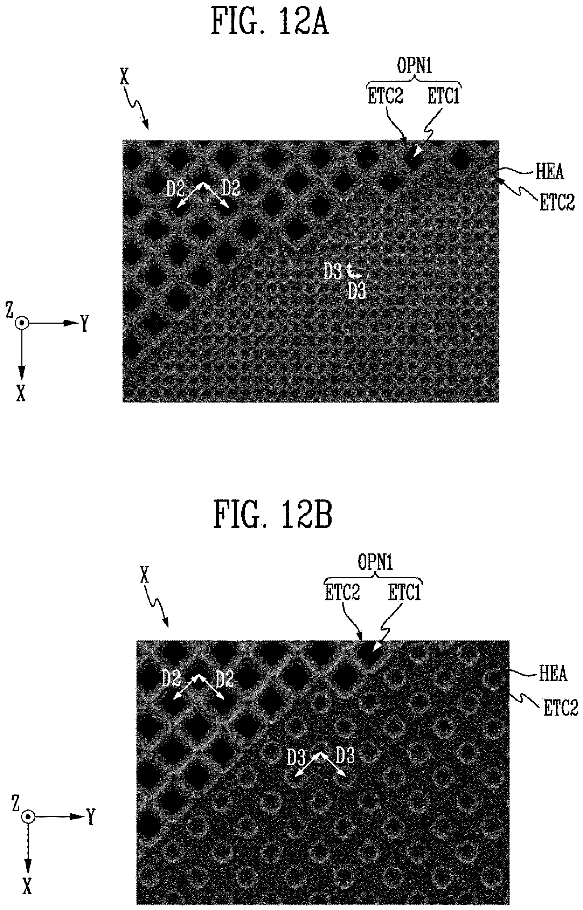

FIGS. 12A and 12B are partially enlarged views of the mask 182 (refer to FIG. 3) in accordance with embodiments of the disclosure. FIG. 12A is a partially enlarged view of an area corresponding to area X of FIG. 6, as an embodiment of the mask 182. FIG. 12A illustrates multiple first openings OPN1 and multiple half-etched areas HEA. The first openings OPN1 may correspond to the first deposition areas DPO1 (refer to FIG. 4 or the like) described above. Each of the first openings OPN1 may include a first etched area ETC1 and a second etched area ETC2. The half-etched area HEA may include a second etched area ETC2.

Referring to FIG. 12A, in the mask in accordance with an embodiment, a distance between the first openings OPN1 adjacent to each other may be greater than a distance between the half-etched areas HEA adjacent to each other. For example, referring to FIG. 12A, the distance (or the pitch) between the first openings OPN1 adjacent to each other in a diagonal direction may be a second distance D2. The diagonal direction may refer to a direction indicated by a vector obtained by the sum of a vector of the X-axis direction and a vector of the Y-axis direction. The distance between the half-etched area HEA adjacent to each other in the X-axis direction or the Y-axis direction may refer to a third distance D3. The third distance D3 may be less than the second distance D2.

FIG. 12B is a partially enlarged view of an area corresponding to area X of FIG. 6 as an embodiment of the mask 182. FIG. 12B illustrates multiple first openings OPN1 and multiple half-etched areas HEA. Referring to FIG. 12B, in the mask in accordance with an embodiment, a distance between the first openings OPN1 adjacent to each other may be the same or substantially the same as a distance between the half-etched areas HEA adjacent to each other. For example, referring to FIG. 12B, the distance between the first openings OPN1 adjacent to each other in the diagonal direction may be a second distance D2. The distance between the half-etched area HEA adjacent to each other in the diagonal direction may refer to a third distance D3. The third distance D3 may be the same or substantially the same as the second distance D2.

In the mask in accordance with an embodiment of FIG. 12A, the half-etched areas HEA may be densely formed. Hence, the amount with which metal components (e.g., stainless steel, invar, nickel (Ni), cobalt (Co), a nickel alloy, or a nickel-cobalt alloy) of the mask itself may be removed may be relatively increased. Consequently, the possibility of deformation of the mask by magnetic force may be reduced.

In the mask in accordance with an embodiment of FIG. 12B, the half-etched areas HEA may be loosely formed. The process of manufacturing the mask in accordance with an embodiment of FIG. 12B may be facilitated.

A mask, a mask assembly including the mask, a display panel manufacturing apparatus including the mask assembly, and a method of manufacturing a display panel using the display panel manufacturing apparatus in accordance with embodiments of the disclosure may improve deposition quality.

## Claims

1. A mask (182) comprising:
a sensor area (320) including at least one half-etched area (HEA);
a first deposition area (DPO1) disposed external to the sensor area (320); and
a second deposition area (DPO2) disposed in the sensor area (320).

2. The mask (182) according to claim 1, wherein
each of the first and the second deposition areas (DPO1, DPO2) includes an opening, and
the opening of each of the first and the second deposition areas (DPO1, DPO2) comprises:
a first etched area (ETC1) formed by etching the mask in a direction from a first surface (510) of the mask toward a second surface (520) of the mask (182); and
a second etched area (ETC2) formed by etching the mask in a direction from the second surface (520) of the mask toward the first surface (510) of the mask (182).

3. The mask (182) according to claim 1 or 2, wherein the half-etched area (HEA) includes the second etched area (ETC2).

4. The mask (182) according to claim 2, wherein a depth (D1) of the second etched area (ETC2) is equal to or greater than half of a thickness (DEP) of the mask (182).

5. The mask (182) according to at least one of claims 1 to 4, wherein the sensor area (320) has a shape selected from a circular ring-type and a pill-like ring-type.

6. A mask assembly (180) comprising:
a mask (182), in particular a mask (182) of at least one of claims 1 to 5, including a sensor area (320) including at least one half-etched area (HEA), at least one first deposition area (DPO1) disposed external to the sensor area (320), and at least one second deposition area (DPO2) disposed in the sensor area (320); and
a mask frame (181) including a global opening (250), the global opening (250) overlapping each of the first deposition area (DPO1), the half-etched area (HEA), and the second deposition area (DPO2).

7. The mask assembly (180) according to claim 6, wherein
each of the first and the second deposition areas (DPO1, DPO2) includes an opening, and
the opening of each of the first and the second deposition areas (DPO1, DPO2) comprises:
a first etched area (ETC1) formed by etching the mask (182) in a direction from a first surface (510) of the mask (182) toward a second surface (520) of the mask (182); and
a second etched area (ETC2) formed by etching the mask (182) in a direction from the second surface (520) of the mask (182) toward the first surface (510) of the mask (182).

8. The mask assembly (180) according to claim 6 or 7, wherein the half-etched area (HEA) includes the second etched area (ETC2).

9. The mask assembly (180) according to at least one of claims 6 to 8, wherein
the mask (182) extends in a first direction and comprises a first portion (AR1), a second portion (AR2), and a third portion (AR3) that are successively disposed,
the first portion (AR1) includes a notch (GRV) recessed by a depth in the first direction,
the second portion (AR2) is coupled to the mask frame (181), and
the third portion (AR3) includes a plurality of unit panel manufacturing areas (310), each of the plurality of unit panel manufacturing areas (310) including the sensor area (320), the first deposition area (DPO1), and the second deposition area (DPO2).

10. The mask assembly (180) according to at least one of claims 6 to 9, wherein the sensor area (320) comprises:
a first sensor area (610a) having a circular ring-type shape; and
a second sensor area (610b) having a pill-like ring-type shape.

11. The mask assembly (180) according to claim 10, wherein a surface area of the second sensor area (610b) is greater than a surface area of the first sensor area (610a).

12. The mask assembly (180) according to claim 10 or 11, wherein a number of openings disposed in the second sensor area (610b) is greater than a number of openings disposed in the first sensor area (610a).

13. A display panel manufacturing apparatus (100), comprising:
a chamber (110);
a deposition source (130) disposed in the chamber (110) that supplies a deposition material in the chamber (110);
a support (140) that couples to a substrate (MSB) on which the deposition material is to be deposited; and
a mask assembly (180), in particular a mask assembly (180) of at least one of claims 6 to 12, overlapping the deposition source (130), the mask assembly (180) comprising a mask (182) including a sensor area (320) including at least one half-etched area (HEA), at least one first deposition area (DPO1) disposed external to the sensor area (320), and at least one second deposition area (DPO2) disposed in the sensor area (320).

14. The display panel manufacturing apparatus (100) according to claim 13, wherein the deposition material includes an organic light emitting material.

15. The display panel manufacturing apparatus (100) according to claim 13 or 14, wherein the substrate (MSB) comprises a pixel circuit layer (PCL) including at least one thin film transistor.

16. A method of manufacturing a display device, comprising:
forming a pixel circuit layer (PCL) including at least one thin film transistor on a base substrate (MSB);
disposing a mask assembly (180), in particular a mask assembly (180) of at least one of claims 6 to 12, to overlap the pixel circuit layer (PCL), the mask assembly (180) comprising a mask (182), in particular a mask (182) of at least one of claims 1 to 5, including a sensor area (320) including at least one half-etched area (HEA), at least one first deposition area (DPO1) disposed external to the sensor area (320), and at least one second deposition area (DPO2) disposed in the sensor area (320); and
forming at least one light emitting element (LE) by depositing using the mask assembly (180) a deposition material on the pixel circuit layer (PCL).

17. The method according to claim 16, further comprising
setting a trim line (TRM) in the base substrate (MSB) in an area corresponding to the sensor area (320); and
forming a light receiving area (LRA) by removing at least a portion of the base substrate (MSB) along the set trim line (TRM).

18. The method according to claim 17, wherein one of the at least one light emitting element (LE) is formed external to the trim line (TRM) at a position adjacent to the trim line (TRM) and is formed in a dummy pixel (DUM) that is not electrically connected to any of the at least one thin film transistor.

19. The method according to claim 18, wherein the light emitting element (LE) of the dummy pixel (DUM) includes a hole.

20. The method according to at least one of claims 17 to 19, wherein one of the at least one light emitting element (LE) is disposed in the trim line (TRM) and is electrically connected to one of the at least one thin film transistor.
